Europäisches Patentamt

European Patent Office

Office européen des brevets

(19)

(11) Veröffentlichungsnummer : **0 413 388 B1**

# (12) EUROPÄISCHE PATENTSCHRIFT

(45) Veröffentlichungstag der Patentschrift :
**29.11.95 Patentblatt 95/48**

(51) Int. Cl.⁶ : **G01R 33/035**

(21) Anmeldenummer : **90202174.0**

(22) Anmeldetag : **10.08.90**

(54) Verfahren zum Unterdrücken von Stromverteilungsrauschen in einem Gleichstrom-SQUID.

(30) Priorität : **16.08.89 DE 3926917**

(43) Veröffentlichungstag der Anmeldung :
**20.02.91 Patentblatt 91/08**

(45) Bekanntmachung des Hinweises auf die
Patenterteilung :
**29.11.95 Patentblatt 95/48**

(84) Benannte Vertragsstaaten :
**DE FR GB**

(56) Entgegenhaltungen :
US-A- 4 663 590
APPLIED PHYSICS LETTERS. Bd. 49, Nr. 20,
17. November1986, NEW YORK US Seiten 1393
- 1395; V. FOGLIETTI ET AL.: 'Low-frequency
noisein low 1/f noise dc SQUIDs'
JOURNAL OF APPLIED PHYSICS. Bd. 64, Nr. 1,
1. Juli 1988,NEW YORK US Seiten 239 - 241; S.
KURIKI ET AL.: 'Effects of alternating biascurrent on the low-frequency noise in dc SQUIDs.'
ELECTRONICS AND COMMUNICATIONS IN
JAPAN. Bd. 72, Nr. 12, Dezember 1989,NEW
YORK US Seiten 84 - 94; M. MATSUDA ET AL.:
'Analysis of Noise Properties ofdc-SQUIDs'

(56) Entgegenhaltungen :
& DENSHI JOHO TSUSHIN GAKKAI RONBUS-
HI Bd. 72CII, Nr. 2, Februar 1989,Seiten 148 -
157;
IEEE TRANSACTIONS ON MAGNETICS. Bd.
MAG23, Nr. 2, März 1987,NEW YORK US Seiten
1150 - 1153; V. FOGLIETTI ET AL: 'A novel
modulationtechnique for 1/f noise reduction in
dc SQUIDs'

(73) Patentinhaber : **Philips Patentverwaltung
GmbH
Röntgenstrasse 24
D-22335 Hamburg (DE)**
(84) DE
Patentinhaber : **Philips Electronics N.V.
Groenewoudseweg 1
NL-5621 BA Eindhoven (NL)**
(84) FR GB

(72) Erfinder : **Lüdeke, Kai-Michael
Pinneberger Chaussee 43
D-2000 Hamburg 54 (DE)**

(74) Vertreter : **Hartmann, Heinrich, Dipl.-Ing. et al
Philips Patentverwaltung GmbH,
Röntgenstrasse 24
D-22335 Hamburg (DE)**

Anmerkung : Innerhalb von neun Monaten nach der Bekanntmachung des Hinweises auf die Erteilung des europäischen Patents kann jedermann beim Europäischen Patentamt gegen das erteilte europä- ische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patent- übereinkommen).

## Beschreibung

Die Erfindung betrifft ein Verfahren zum Unterdrücken von Stromverteilungsrauschen in einem Gleichstrom-SQUID mit zwei in einer supraleitenden Schleife angeordneten Josephsonkontakten gemäß dem Oberbegriff des Anspruchs 1.

Ein solches Verfahren ist aus der US-A-4 663 590 bekannt.

Zur Messung schwacher Magnetfelder in einem Feldstärkebereich unter $10^{-10}$ Tesla werden supraleitende Quanten-Interferenz-Elemente verwendet, die als SQUIDS (Superconducting Quantum Interference Devices) bezeichnet werden und beispielsweise zur Messung der Magnetfelder bei der Magnetokardiographie, Magnetoenzephalographie oder auch bei der Lebersuszeptometrie eingesetzt werden. Entsprechende Meßvorrichtungen enthalten neben dem SQUID ein Gradiometer, eine Einkoppelspule und eine Modulationsspule innerhalb eines Kryosystems für den Tieftemperaturbereich zur Herstellung der Supraleitung. Die Modulationsspule ist mit einer Modulations- bzw. Steuereinrichtung verbunden, die ihrerseits mit dem SQUID verbunden ist. Die Modulationseinrichtung ist mit einer Auswerte- bzw. Signaldetektionseinrichtung verbunden. Das SQUID besteht aus einer geschlossenen supraleitenden Schleife, die von zwei Josephsonkontakten unterbrochen wird. Zwischen den Kontakten ist ein nicht supraleitender Gleichstromanschluß vorgesehen. Die Spannung zwischen den Anschlüssen variiert abhängig vom eingekoppelten Magnetfeld, sofern nicht als Indikator mittels der Modulationsspule ein entgegengesetztes Magnetfeld erzeugt werden würde, ("Flux-locked-loop" Modulationsverfahren). Die Josephsonkontakte derartiger SQUIDS weisen sehr kleine Kontaktflächen auf, um eine hohe Empfindlichkeit zu erzeugen. Durch abwechselndes Steckenbleiben und wieder Freiwerden von Elektronen ("trapping of electrons") in der isolierenden Barriere dieser Josephsonkontakte unterliegt die Potentialschwelle der Barriere und damit auch ihr kritischer Strom zeitlichen Schwankungen, was ein Stromverteilungsrauschen im SQUID mit 1/f-förmigem Frequenzverhalten zur Folge hat. Bei Josephsonkontakten mit extrem kleinen Flächen treten als weitere Ursache außerdem thermodynamisch bedingte Schwankungen der kritischen Ströme auf.

Verfahren und/oder Schaltungsanordnungen, die dieses Problem betreffen, sind bekannt. So geht beispielsweise aus dem europäischen Patent 0 053 625 eine Schaltungsanordnung mit einem Gleichstrom-SQUID hervor, die in einer supraleitenden Schleife verbundene Josephsonkontakte aufweist, ferner eine Steuereinrichtung zum Anlegen eines Vorspannstroms durch die Übergänge, wobei die Steuereinrichtung derart ausgebildet ist, daß die Polarität des Vorspannstroms mit einer ersten Frequenz umgekehrt wird. Zum Erzeugen eines induzierten Modulationswechselstromes in der Schleife sind Modulationsmittel vorgesehen, zur Modulation mit einer zweiten von der ersten verschiedenen vorgegebenen Frequenz. Ferner sind Mittel zum Erzeugen eines Ausgangssignals vorgesehen und ein Demodulator, der dieses Ausgangssignal erhält, um es mit einem diese zweite Frequenz aufweisenden Signal zu kombinieren, um ein demoduliertes Ausgangssignal zu erhalten. Bei dieser Schaltungsanordnung und auch bei dem bekannten Verfahren nach Kuriki, Matsuda, Matachi "Effects of alternating bias current on the low-frequency noise in dc SQUIDs" J.Appl.Phys. 64 (1), 1. July 1988, pp. 239 - 241, wird eine Flußmodulation und ein Vorspannstrom mit verschiedenen Frequenzen moduliert. Entsprechend der europäischen Patentschrift beispielsweise in einem Fluß-/Strom-Frequenzverhältnis von 1 : 4 oder nach Kuriki et al. von 8 : 1 und bei einem weiter bekannten Bio-Magnetometer von 1 : 4,5. Bei dieser Vorgehensweise ist es besonders aufwendig, die Modulations- und Demodulationssignale zu erzeugen. Nachteilig ist weiterhin, daß das Nutzsignal auf ein breites Spektrum von Kombinationsfrequenzen verteilt wird. Da die niedrigere der beiden Modulationsfrequenzen größer als die gewünschte Signalbandbreite gewählt werden muß, bestimmt die höhere der beiden Modulationsfrequenzen und die noch mitzuverarbeitenden höheren Kombinationsfrequenzen die erforderliche Bandbreite der Signaldetektionseinrichtung. Die Signaldetektionseinrichtung enthält im Eingangsteil einen aufwärts transformierenden Koppeltransformator und einen rauscharmen Feldeffekt-Transistor als erstes verstärkendes Element. Da die Eingangskapazität des Verstärkers und die Streuinduktivität des Trafos die obere Grenzfrequenz des Signalpfades bestimmen, kann das Übersetzungsverhältnis des Transformators nicht so hoch gewählt werden, wie es zur Erzielung eines ausreichend niedrigen Rauschbeitrages des Vorverstärkers wünschenswert wäre.

Aus Foglietti, Gallagher, Koch "A novel modulation technique for 1/f noise reduction in dc SQUIDs", IEEE MAG 23, No. 2, 1987, pp. 1150 - 1153, ist ein Verfahren bekannt, bei dem der SQUID nacheinander durch vier Vorspannzustände geführt wird, von denen die Zustände 2 und 4 inaktiv sind. Durch die beiden inaktiven Vorspannzustände tritt in der Fourierreihenentwicklung der Signalspannung auf den Nutzsignalfrequenzen gegenüber dem Standard Flux-locked-loop Verfahren ein Verlust in der Transferfunktion (Fluß in Spannung) auf, so daß eine zwar im Bereich des 1/f-Rauschens erzielbare Rauschverminderung einhergeht mit einer Verschlechterung des Abstandes von Signalleistung zu Rauschleistung um den Faktor 2 im Bereich des weißen Rauschens gegenüber dem des Standard Flux-locked-loop Verfahrens.

Nicht hysteretische Gleichstrom-SQUIDs weisen integrierte Parallel-Widerstände auf und werden entweder mit konstantem Vorspannstrom (Standard Flux-locked-loop Verfahren) oder mit periodisch umgepolten Vorspannstrom entsprechend dem oben genannten Verfahren betrieben.

Bei hysteretischen Gleichstrom-SQUIDs mit Josephson-Tunnel-Kontakten ohne integrierte Parallel-Widerstände kann durch Betrieb mit einer sägezahnförmigen Stromfunktion ein periodisches Durchlaufen der Hysteresekurve erzwungen werden, wie aus P. Gutmann "Two junction SQUID using a sampling technique, in SQUIDs and their applications", Eds.: Hahlbohm, LÜbbig, 1977, pp. 501 - 509, und O.V. Snigirev "Ultimate sensitivity of the dc SQUIDs using unshunted Josephson-Tunnel junctions", IEEE MAG-19, No. 3, May 1983, pp. 584 - 586, bekannt ist. Pro Zyklus wird der flußabhängige kritische Strom in eine Puls-/Tastverhältnis modulierte Ausgangsspannung umgewandelt, die dann meßtechnisch erfaßt werden kann. Obgleich hierbei der Konversionsfaktor - Fluß in Spannung - bereits größer und somit besser ist als bei rauschoptimierten nicht hysteretischen Gleichstrom-SQUIDs, so haftet auch diesen Verfahren ein nachteiliges erhebliches Stromverteilungsrauschen an.

Der vorliegenden Erfindung liegt die Aufgabe zugrunde, ein Verfahren zu schaffen, das bei gleichzeitiger struktureller Einfachheit geeignet ist, das Rauschen, das in Gleichstrom-SQUIDs durch individuelle Schwankungen der kritischen Ströme der beiden Josephson-Kontakte entsteht, zu unterdrücken.

Erfindungsgemäß wird diese Aufgabe durch die Kennzeichnenden Merkmale des Anspruchs 1 gelöst.

Beim erfindungsgemäßen Verfahren wird das Standard Flux-locked-loop Verfahren angewandt, bei dem um den quasistatischen Flußarbeitspunkt über eine Spule eine Flußmodulation um ein Viertel des Flußquants $\emptyset \approx 2 \cdot 10^{-15}$ $W_b$ durchgeführt wird und zusätzlich der Vorspannstrom mit gleicher Frequenz aber einem Zeitversatz von einem Viertel der Periodendauer der Modulationsfrequenz periodisch umgepolt wird. Durch diese Maßnahme, die durch eine Modulations- und Steuereinrichtung sichergestellt wird, durchläuft der SQUID nacheinander vorzugsweise vier Vorspannzustände. In einer nachgeordneten Signaldetektionseinrichtung wird dann die mittlere Ausgangsspannung aus der Summe der vorzeichenmäßig bewerteten vier Ausgangsspannungen gebildet, wobei die vier Ausgangsspannungen aus je einer Spannung eines Arbeitspunktes, der durch den zeitlich versetzten Vorspannstrom festgelegt ist, und deren Ableitungen nach dem Fluß $\emptyset$ im jeweilgen Arbeitspunkt gebildet werden.

Die einzelnen Summanden der mittleren Ausgangsspannung werden erfindungsgemäß aus einer Summe von vier Termen gebildet. Einer der Terme repräsentiert die entsprechende Spannung im entsprechenden Arbeitspunkt. Zwei weitere Terme beinhalten den mittleren kritischen Strom und die Meßgröße.

Über den vierten Term wird eine mögliche Asymmetrie des SQUIDs berücksichtigt. Aufgrund des Vorspannstromes ergibt sich erfindungsgemäß, daß die Spannung im Arbeitspunkt 3 der negativen Spannung im Arbeitspunkt 1 und die Spannung im Arbeitspunkt 4 der negativen Spannung im Arbeitspunkt 2 entspricht. Im Fall eines symmetrischen SQUIDs kann eine Vereinfachung dahingehend eingeführt werden, daß die Spannung im Arbeitspunkt 2 der im Arbeitspunkt 1 entspricht und die Summe aus deren partiellen Ableitungen nach dem Fluß $\emptyset$ Null ergibt.

Erfindungsgemäß ist vorgesehen, daß in der Signaldetektionseinrichtung eine Signaldetektion auf der Modulationsfrequenz mit einer nacheinander paarweise gleichen Bewertungsfolge (++--) erfolgt. Die hierbei ermittelte mittlere Ausgangsspannung wird zum automatischen Abgleich einer Brückenschaltung herangezogen, zur Kompensation des Mittelwertes dieser mittleren Ausgangsspannung vor einem beispielsweise nachgeschalteten Signalverstärker.

Es kann auch vorgesehen sein, daß in der Signaldetektionseinrichtung eine Signaldetektion auf der Modulationsfrequenz in Quadraturphase mit einer symmetrischen Bewertungsfolge (+--+) durchgeführt wird.

Bei symmetrischem SQUID ergeben sich jeweils Vereinfachungen bei der Ermittlung der mittleren Ausgangsspannung.

Gegenüber der eingangs genannten Schaltungsanordnung nach der europäischen Patentschrift 0 053 625 und dem Verfahren nach Kuriki et al., bei denen der Fluß- und der Vorspannstrom mit verschiedenen Frequenzen moduliert wird, vereinfacht sich beim erfindungsgemäßen Verfahren die Erzeugung der Modulations- und Demodulationssignale. Gegenüber Verfahren mit halbzahligem Frequenzverhältnis ist weiterhin von Vorteil, daß im Signalspektrum keine Kombinationsfrequenzen unterhalb der Modulationsfrequenz auftreten.

Ferner ist bei vergleichbarer Signalbandbreite bei dem hier vorgeschlagenen erfindungsgemäßen Quadratur-Modulationsverfahren eine Reduktion der Bandbreite vor Detektion, speziell der der oberen Grenzfrequenz des Signalpfades vom SQUID zum Demodulator gegenüber dem bekannten Verfahren zulässig, was mittelbar zu einer Verminderung des Rauschbeitrages eines Eingangsverstärkers genutzt werden kann. Es erlaubt nämlich den Einsatz von Feldeffekttransistoren mit niedrigerer Rauschspannung und größerer Eingangskapazität im Vorverstärker und den Einsatz von Koppeltransformatoren mit höherem Übersetzungsverhältnis und größerer Streuinduktivität und Streukapazität zwischen dem SQUID und dem Vorverstärker. Durch das höhere Übersetzungsverhältnis verringert sich der Beitrag des Vorverstärkers zum Gesamtrauschen. Die durch erhöhte Streuinduktivität und Eingangskapazität eintretende Erniedrigung der oberen Grenzfrequenz ist beim erfindungsgemäßen Verfahren ohne Nachteil.

Gegenüber dem eingangs genannten Verfahren nach Foglietti et al. treten beim erfindungsgemäßen Verfahren nur aktive Vorspannzustände auf, so daß eine Verschlechterung des Signalrauschabstandes im Bereich des weißen Rauschens vermieden wird.

Das erfindungsgemäße Verfahren kann auch bei hysteretischen Gleichstrom-SQUIDs mit Josephsonkontakten ohne integrierte Parallel-Widerstände Anwendung finden. Nicht hysteretische Gleichstrom-SQUIDs mit integrierten Parallel-Widerständen werden entweder mit konstantem Vorspannstrom oder periodisch umgepoltem Vorspannstrom betrieben. Bei hysteretischen Gleichstrom-SQUIDs kann durch Betrieb mit einem sägezahnförmigen Vorspannstrom ein periodisches Durchlaufen der - aus dem supraleitenden Kennlinienteil und der Tunnelkennlinie der Elektronen (der sogenannten Quasipartikel) bestehenden - Hysteresekurve erzwungen werden, wie es aus den eingangs genannten Quellen Gutmann und Snigirev bekannt ist.

Bei diesen Verfahren für hysteretische Gleichstrom-SQUIDs steuert die Steuereinrichtung den Vorspannstrom derart, daß er innerhalb eines Vorspannzustandes betragsmäßig von einem Strom unterhalb eines kleinsten kritischen Stromes linear auf einen Strom oberhalb eines größten kritischen Stromes ansteigt und anschließend kurz abgeschaltet wird, um den SQUID wieder in den spannungslosen Zustand zu versetzen. Um auch bei diesen Verfahren für hysteretische Gleichstrom-SQUIDs das Stromverteilungsrauschen zu unterdrücken, ist erfindungsgemäß vorgesehen, daß nach jeweils zwei Vorspannzuständen das Vorzeichen des Vorspannstromes gewechselt wird, wobei die Flußmodulation in Einheiten von ø/4 in den vier Zuständen mit der Bewertungsfolge + - - + erfolgt. Dadurch wird pro Vorspannzustand der flußabhängige kritische Strom in eine Puls-/Tastverhältnis modulierte Ausgangsspannung umgewandelt, die mit bekannten meßtechnischen Methoden erfaßt werden kann.

Es sei erwähnt, daß vorteilhaft der Signaldetektionseinrichtung, wie bereits erwähnt, ein Vorverstärker vorgeschaltet sein kann.

Weitere bevorzugte Ausgestaltungen des erfindungsgemäßen Verfahrens ergeben sich aus den Unteransprüchen.

Ein Ausführungsbeispiel der Erfindung wird nachfolgend unter Bezugnahme auf eine Zeichnung näher erläutert. Es zeigt:

Fig. 1 eine schematisierte Darstellung einer Vorrichtung zur Durchführung des erfindungsgemäßen Verfahrens,

Fig. 2 einen Spannungsverlauf in einem symmetrischen und asymmetrischen Gleichstrom-SQUID in Abhängigkeit eines Flusses ø und über einen Vorspannstrom beispielhaft festgelegte Arbeitspunkte, und

Fig. 3 einen sägezahnförmigen Vorspannstrom für ein hysteretisches Gleichstrom-SQUID.

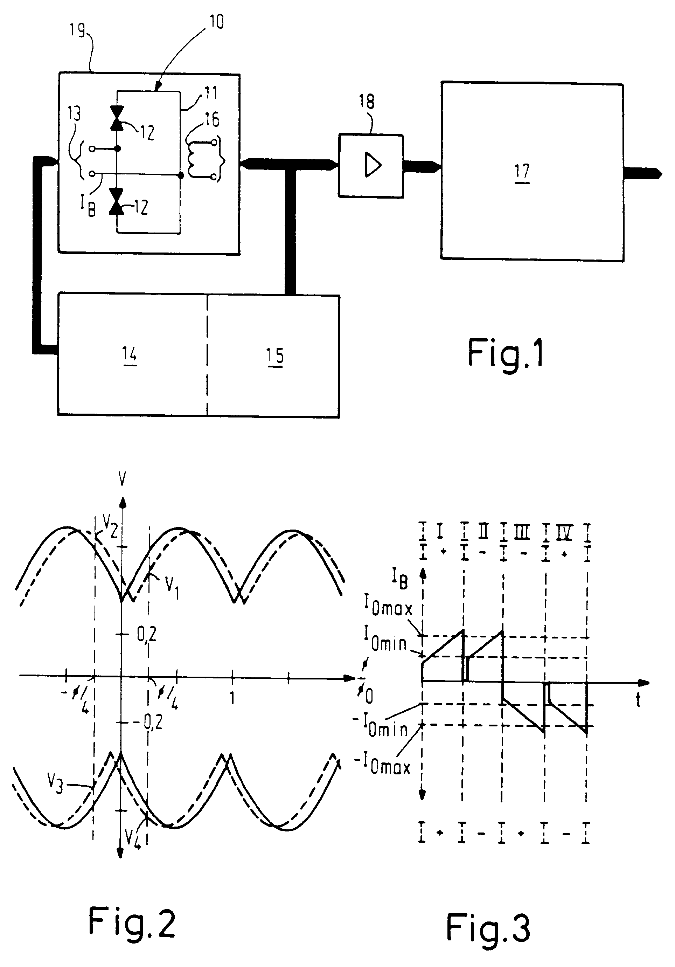

Fig. 1 zeigt schematisch diejenigen Bestandteile einer Vorrichtung zur Durchführung des erfindungsgemäßen Verfahrens, die zur Beeinflussung und Detektion eines SQUIDs notwendig sind. Ein nicht dargestelltes Gradiometer und eine Einkoppelspule, die einen geschlossenen supraleitenden Stromkreis bilden, erfassen das zu messende Magnetfeld und transformieren es in ein vereinfacht dargestelltes Gleichstrom-SQUID 10, bestehend aus einer supraleitenden Schleife 11 und zwei in Reihe angeordneten Josephsonkontakten 12. Zwischen den Josephsonkontakten 12 ist ein nicht supraleitender Gleichstromanschluß 13 vorgesehen. Der Gleichstromanschluß 13 ist mit einer Steuereinrichtung 14 verbunden, die ihrerseits mit einer Modulationseinrichtung 15 verknüpft ist, die auf eine Modulationsspule 16, zur Erzeugung einer Flußmodulation über einen induzierten Wechselstrom in der Schleife 11 des SQUIDs 10 wirkt und gleichzeitig über einen Vorverstärker 18 mit einer Signaldetektioneinrichtung 17 zur Detektion und Kombination der Signale aus dem SQUID 10, der Steuereinrichtung 14 und der Modulationseinrichtung 15 verbunden ist. Der Signaldetektionseinrichtung 17 kann ferner ein weiterer, nicht dargestellter Signalverstärker nachgeschaltet sein. Die Umrandung 19 deutet an, welche Teile der Vorrichtung in einem Kryosystem für den Tieftemperaturbereich zur Herstellung der Supraleitung untergebracht sind. Auch das nicht dargestellte Gradiometer und die Einkoppelspule befinden sich in dem Kryosystem 19. Weitere ggf. notwendige Vorrichtungsbestandteile z.B. zur Erzeugung und weiteren Verarbeitung der Signale sind im Stand der Technik bekannt und daher nicht dargestellt.

Fig. 2 zeigt den Spannungs-/Flußverlauf für positiven und negativen Vorspannstrom, gestrichelt für ein asymmetrisches und nicht gestrichelt für ein symmetrisches Gleichstrom-SQUID.

Wird zusätzlich zu der im Standard Flux-locked-loop Verfahren angewandten Flußmodulation mit etwa $\pm \emptyset_0/4$ erfindungsgemäß der Vorspannstrom $I_B$ periodisch mit gleicher Frequenz aber einem Zeitversatz von einem Viertel der Periodendauer des modulierten Flusses ø durchgeführt, dann durchläuft ein asymmetrisches Gleichstrom-SQUID die gestrichelte Kurve und ein symmetrisches Gleichstrom-SQUID die ausgezogene Kurve. Für den allgemeinen Fall, also ein asymmetrisches SQUID sind die Spannungen $V_1$, $V_2$, $V_3$, $V_4$ für die entsprechenden Arbeitspunkte eingezeichnet und weisen einen Zeitversatz von einem Viertel der Periodendauer des modulierten Flusses ø auf. Der SQUID durchläuft nacheinander vier Vorspannzustände, z.B. in einer Reihenfolge (+ - - +) für den Vorspannfluß in Einheiten von etwa $\emptyset_0/4$ bei einer Polarität des Vorspannstromes $I_B$ von (+ + - -).

In der Signaldetektionseinrichtung 17 wird eine mit jedem Zustand das Vorzeichen wechselnde Bewertung durchgeführt, wodurch sich in der Signalsumme über die vier Zustände die aus den Schwankungen der kritischen Ströme resultierenden Stromverteilungsrauschsignale gegenseitig aufheben. Bei einer Meßgröße $\delta\emptyset$ (t), einem mittleren kritischen Strom $I_o + \delta I_o$ (t) = ($I_{o1}$ (t) + $I_{o2}$ (t))/2, einer Asymmetrie $\alpha + \delta(t) = (I_{o1}$ (t) - $I_{o2}$ (t))/($I_{o1}$ (t) + $I_{o2}$ (t)) und Spannungen im Arbeitspunkt

$V_3 = -V_1$, $V_4 = -V_2$, wobei $V_{oi}$ eine Ausgangsspannung repräsentiert, ergibt sich eine mittlere Ausgangsspannung von $V_{ges} = V_{o1} - V_{o2} + V_{o3} - V_{o4}$.

Mit

$V_{o1} = V_1 + \partial V_1/\partial I_o \delta I_o$ (t) + $\partial V_1/\partial \alpha \delta \alpha(t)$ + $\partial V_1/\partial \emptyset \delta \emptyset$ (t);

$V_{o2} = V_2 + \partial V_2/\partial I_o \delta I_o$ (t) + $\partial V_2/\partial \alpha \delta \alpha(t)$ + $\partial V_2/\partial \emptyset \delta \emptyset$ (t);

$V_{o3} = -V_1 - \partial V_1/\partial I_o \delta I_o$ (t) - $\partial V_1/\partial \alpha \delta \alpha(t)$ + $\partial V_1/\partial \emptyset \delta \emptyset$ (t)

und

$V_{o4} = -V_2 - \partial V_2/\partial I_o \delta I_o$ (t) - $\partial V_2/\partial \alpha \delta \alpha(t)$ + $\partial V_2/\partial \emptyset \delta \emptyset$ (t)

ergibt sich eine mittlere Ausgangsspannung $V_{ges}$ zu 2 ($\partial V_1/\partial \emptyset - \partial V_2/\partial \emptyset$)$\delta\emptyset$ (t), die nur noch der Meßgröße proportional ist. Hierbei ist $\partial V_1/\partial \emptyset > 0, \partial V_2/\partial \emptyset < 0$, so daß der Klammerausdruck insgesamt positiv ist. Die hier eingesetzten Vorzeichen der Spannungen $V_1$, $V_2$ und ihrer partiellen Ableitungen im jeweiligen Arbeitspunkt und die ausgenutzte Betragsgleichheit der Arbeitspunkte in den Zuständen 1, 3 und 2, 4 ergibt sich aus den Symmetrieeigenschaften der in Fig. 2 dargestellten Kennlinie. Bei symmetrischen SQUIDs gilt zusätzlich, wie aus Fig. 2 ersichtlich, $V_2 = V_1$, $\partial V_2/\partial \emptyset = -\partial V_1/\partial \emptyset$.

Bei einer Signaldetektion auf der Modulationsfrequenz mit einer anderen Bewertungsfolge, nämlich (+ + - -), ist

$V_{ges} = V_{o1} + V_{o2} - V_{o3} - V_{o4} = 2 * (V_1 + V_2 + (\partial V_1/\partial I_o + \partial V_2/\partial I_o)\delta I_o$ (t) + $(\partial V_1/\partial \alpha + \partial V_2/\partial \alpha)\delta\alpha(t))$ mit $\partial V_1/\partial \alpha * \partial V_2/\partial \alpha < 0$.

Bei Symmetrie ist $V_{ges} = 4 (V_1 + \partial V_1/\partial I_o \delta I_o$ (t)). Dieses Signal kann zum automatischen Abgleich einer nicht dargestellten Brückenschaltung herangezogen werden, die den Mittelwert $<V_{o1} + V_{o2} - V_{o3} - V_{o4}>$ vor dem gegebenenfalls vorhandenen Signalverstärker kompensiert.

Bei einer Signaldetektion auf der Modulationsfrequenz in Quadraturphase mit einer Bewertung von (+ - - +) ist

$V_{ges} = V_{o1} - V_{o2} - V_{o3} + V_{o4} = 2 * (V_1 - V_2 + (\partial V_1/\partial I_o - \partial V_2/\partial I_o)\delta I_o$ (t) + $(\partial V_1/\partial \alpha - \partial V_2/\partial \alpha)\delta\alpha(t))$.

Bei Symmetrie ist $V_{ges} = 4\partial V_1/\partial \alpha \delta \alpha(t)$.

Mit dem erfindungsgemäßen Verfahren ist es somit möglich, für nicht hysteretische Gleichstrom-SQUIDs mit nicht dargestellten integrierten Parallel-Widerständen eine aufgabengemäße Unterdrückung von Stromverteilungsrauschen zu erreichen.

Fig. 3 zeigt einen sägezahnförmigen Vorspannstrom $I_B$, der zu Beginn eines jeden Vorspannzustandes betragsmäßig von einem Wert kleiner eines kleinsten kritischen Stromes $I_{o-min}$ linear auf einen Wert größer einem größten kritischen Strom $I_{o-max}$ am Ende eines jeden Vorspannzustandes ansteigt, anschließend kurz abgeschaltet wird, um dem SQUID wieder in den spannungslosen Zustand zu versetzen, und nach jeweils zwei Vorspannzuständen das Vorzeichen wechselt. Hierdurch kann bei nachfolgender erfindungsgemäßen alternierenden Signalbewertung bei der Signaldetektion in der Signaldetektionseinrichtung 17 auch für hysteretische Gleichstrom-SQUIDs ohne integrierte Parallel-Widerstände eine Unterdrückung von Stromverteilungsrauschen erreicht werden. In Fig. 3 sind die vier Vorspannzustände mit römischen Ziffern gekennzeichnet, die Vorzeichen der Vorspannung des Flußes darunter und am unteren Rand der Fig. 3 die Vorzeichen der Signalbewertung.

**Patentansprüche**

1. Verfahren zum Unterdrücken von Stromverteilungsrauschen in einem Gleichstrom-SQUID mit zwei in einer supraleitenden Schleife (11) angeordneten Josephson-Kontakten (12), der verbunden ist mit einer Vorrichtung, die eine Modulationseinrichtung (15) zur Erzeugung einer Flußmodulation über einen induzierten Wechselstrom in der Schleife (11), eine Steuereinrichtung (14) zur Erzeugung eines periodischen Vorspannstromes ($I_B$), der mit der Modulationsfrequenz des Flusses und einem Zeitversatz von einem Viertel der Periodendauer der Modulationsfrequenz umgepolt wird, wodurch der SQUID (10) verschiedene Vorspannzustände durchläuft, und eine Signaldetektionseinrichtung (17) zur Signaldetektion enthält, in der eine mit jedem Vorspannzustand das Vorzeichen berücksichtigende Bewertung durchgeführt wird derart, daß die Summe aus mehreren derart bewerteten Ausgangsspannungen ($V_{01}$, $V_{02}$, $V_{03}$, $V_{04}$) eine nur zur Meßgröße proportionale mittlere Ausgangsspannung ($V_{ges}$) ist, dadurch gekennzeichnet, daß in der Signaldetektionseinrichtung (17) eine Signaldetektion auf der einfachen Modulationsfrequenz mit einer nacheinander paarweise gleichen Bewertungsfolge erfolgt, wobei die mittlere Ausgangsspannung ($V_{ges}$) zum automatischen Abgleich einer Brückenschaltung herangezogen wird, die den Mittelwert dieser mittleren Ausgangsspannung ($V_{ges}$) kompensiert.

2. Verfahren nach Anspruch 1, dadurch gekennzeichnet, daß in der Signaldetektionseinrichtung (17) eine Signaldetektion auf der einfachen Modulationsfrequenz in Quadraturphase mit einer symmetrischen Bewertungsfolge durchgeführt wird.

3. Verfahren nach einem der vorhergehenden Ansprüche,
dadurch gekennzeichnet, daß die Steuereinrichtung (14) für einen hysteretischen Gleichstrom-SQUID den Vorspannstrom ($I_B$) derart steuert, daß er betragsmäßig in einem ersten Vorspannzustand einer Halbperiode monoton ansteigt, kurz unterbricht und in dem folgenden Vorspannzustand dieser Halbperiode wieder monoton ansteigt und in der folgenden Halbperiode spiegelbildlich verläuft.

4. Verfahren nach Anspruch 3,
dadurch gekennzeichnet, daß die Steuereinrichtung (14) den Vorspannstrom ($I_B$) derart steuert, daß er betragsmäßig von einem Strom unterhalb eines kleinsten kritischen Stroms ($I_{0\text{- min}}$) linear auf einen Strom oberhalb eines größten kritischen Stroms ($I_{0\text{- max}}$) ansteigt.

## Claims

1. A method of suppressing current distribution noise in a DC SQUID which comprises two Josephson junctions (12) in a superconducting loop (11) and which is connected to a device which comprises a modulation device (15) for generating a flux modulation via an induced AC current in the loop (11), a control device (14) for generating a periodic bias current ($I_B$) whose polarity is reversed with the modulation frequency of the flux and a time shift amounting to one quarter of the period duration of the modulation frequency so that the (SQUID) 10 assumes different bias states, and a signal detection device (17) for signal detection in which a weighting operation is performed for each bias state, taking into account the sign, in such a manner that the sum of a plurality of output voltages ($V_{01}$, $V_{02}$, $V_{03}$, $V_{04}$) thus weighted is a mean output voltage ($V_{ges}$) which is proportional to the measuring quantity only, characterized in that the signal detection device (17) performs a signal detection on the single modulation frequency with a successively pairwise equal weighting sequence, the mean output voltage ($V_{ges}$) being used for the automatic balancing of a bridge circuit which compensates the mean value of this mean output voltage ($V_{ges}$).

2. A method as claimed in Claim 1, characterized in that the signal detection device (17) performs a signal detection on the single modulation frequency in quadrature phase with a symmetrical weighting sequence.

3. A method as claimed in any one of the preceding Claims, characterized in that the control device (14) controls the bias current ($I_B$) for a hysteretic DC SQUID so that, in an absolute sense, it increases monotonously in a first bias state for one half period, is briefly switched off, monotonously increases again in the next bias state of this half period, and varies in a mirror-image fashion during the next half period.

4. A method as claimed in Claim 3, characterized in that the control device (14) controls the bias current ($I_B$) so that, in an absolute sense, it increases linearly from a current below a smallest critical current ($I_{0\text{- min}}$) to a current above a largest critical current ($I_{0\text{- max}}$).

## Revendications

1. Procédé de suppression du bruit de répartition du courant dans un squid à courant continu possédant deux jonctions à effet Josephson (12) disposées dans une boucle supraconductrice (11) qui est relié à un dispositif possédant un dispositif de modulation (15) en vue de la production d'une modulation de flux par l'intermédiaire d'un courant alternatif induit dans la boucle (11), un dispositif de commande (14) en vue de la production d'un courant de polarisation périodique ($I_B$) dont la polarité est inversée avec la fréquence de modulation du flux et un décalage temporel d'un quart de la durée de période de la fréquence de modulation, le squid (10) traversant ainsi différents états de polarisation, et un dispositif de détection de signal (17) en vue de la détection du signal, dans lequel une évaluation prenant en considération le signe avec chaque état de polarisation est effectuée de telle sorte que la somme de plusieurs tensions de sortie ($V_{01}$, $V_{02}$, $V_{03}$, $V_{04}$) évaluées de cette manière soit une tension de sortie moyenne proportionnelle seulement à la grandeur de mesure ($V_{ges}$), caractérisé en ce que, dans le dispositif de détection de signal (17), une détection du signal intervient sur la fréquence de modulation simple avec une séquence d'évaluation identique par paires successives, la tension de sortie moyenne ($V_{ges}$) étant utilisée pour l'égalisation automatique d'un montage en pont qui compense la valeur médiane de cette tension de sortie moyenne ($V_{ges}$).

2. Procédé selon la revendication 1, caractérisé en ce que le dispositif de détection du signal (17) procède à une détection de signal sur la fréquence de modulation simple en phase de quadrature avec une séquence d'évaluation symétrique.

3. Procédé selon l'une quelconque des revendications précédentes, caractérisé en ce que le dispositif de commande (14) pour un squid à courant continu hystérétique commande le courant de polarisation ($I_B$), de telle sorte qu'il augmente linéairement dans un premier état de polarisation d'une demi-période, s'interrompt brièvement et augmente à nouveau linéairement dans l'état de polarisation suivant de cette demi-période et présente un tracé symétrique lors de la demi-période suivante.

4. Procédé selon la revendication 3, caractérisé en ce que le dispositif de commande (14) commande le courant de polarisation ($I_B$) de telle sorte qu'il augmente linéairement pour passer d'un courant inférieur à un courant critique minimal ($I_{0\text{-}min}$) à un courant supérieur à un courant critique maximal ($I_{0\text{-}max}$).

Fig.1

Fig.2

Fig.3